# EUROPÄISCHE PATENTSCHRIFT

(11) **EP 1 908 340 B1**
(45) Veröffentlichungstag und Bekanntmachung des Hinweises auf die Patenterteilung: **26.02.2014**
(21) Anmeldenummer: 06763779.3
(22) Anmeldetag: 20.06.2006
(51) Int. Cl.: H05K 13/04

(54) **MODULAR AUFGEBAUTE VORRICHTUNG ZUM BESTÜCKEN VON SUBSTRATEN**
DEVICE WITH A MODULAR CONSTRUCTION FOR LOADING SUBSTRATES WITH ELECTRONIC COMPONENTS
DISPOSITIF MODULAIRE PERMETTANT D'EQUIPER DES SUBSTRATS

(30) Priorität: 28.07.2005 DE 102005035420
(43) Veröffentlichungstag der Anmeldung: 09.04.2008
(73) Patentinhaber: ASM Assembly Systems GmbH & Co. KG, 81379 München (DE)
(72) Erfinder: MÜLLER, Werner, 83607 Holzkichen (DE)
(74) Vertreter: Kuhlmann, Kai
(86) Internationale Anmeldenummer: PCT/EP2006/063326
(87) Internationale Veröffentlichungsnummer: WO 2007/012525

(56) Entgegenhaltungen:
- EP-A- 1 395 106
- EP-B1- 1 174 014
- WO-A1-2004/075618
- US-A- 5 084 959

## Beschreibung

Die Erfindung betrifft eine Vorrichtung zum Bestücken von Substraten mit Objekten, insbesondere zum Bestücken von Bauelementeträgern mit elektronischen Bauelementen. Die Bestückvorrichtung weist einen modularen Aufbau auf, so dass bei Bedarf einzelne Komponenten der Bestückvorrichtung auf einfache Weise und zügig ausgetauscht werden können.

Aus der DE 3630178 A1 ist eine modular aufgebaute Bestückvorrichtung bekannt, welche eine zentrale Transportstation mit einer Transporteinrichtung zum linearen Transportieren von zu bestückenden Werkstückträgern bzw. Substraten aufweist. An die Transportstation sind Arbeits- und Magazinstationen ankoppelbar, welche jeweils über definierte elektrische, pneumatische und mechanische Schnittstellen in einer genau definierten Lage relativ zu der Transportstation fixiert werden können. Die Arbeitsstationen weisen einen Bestückkopf zum Aufnehmen, Transportieren und Absetzen von elektronischen Bauelementen auf ein Substrat auf. Der Bestückkopf ist mittels eines Positioniersystems entlang zweier Bewegungsrichtungen positionierbar. Die Magazinstationen, welche ebenfalls in einer genau definierten räumlichen Lage relativ zu der Transportstation fixiert werden können, weisen eine Mehrzahl von Zuführeinrichtungen auf, welche zum sequentiellen Zuführen von einzelnen Bauelementen an genau definierte Bauelement-Abholpositionen eingerichtet sind. Da jedoch mit zunehmender Miniaturisierung von elektronischen Baugruppen die Anforderungen hinsichtlich der Präzision einer Bestückung erheblich gestiegen sind, ist bei der genannten Bestückvorrichtung nach einem Umbau eine erneute Kalibrierung der gesamten Bestückvorrichtung erforderlich, so dass der Bestückbetrieb für eine nicht unerhebliche Zeitspanne unterbrochen werden muss.

Aus der EP 1174014 B1 ist ein Bestückkopf bekannt, welcher einen eigenen Datenspeicher aufweist, in welchem die genauen geometrischen Daten des Bestückkopfes abgespeichert werden können. Bei einem Einbau des Bestückkopfes in eine Bestückvorrichtung werden diese Daten ausgelesen und an eine Steuereinheit des Bestückkopfes übermittelt. Bei nachfolgenden Bestückvorgängen werden gegebenenfalls vorhandene geometrische Abweichungen von einer Sollgeometrie des aktuell verwendeten Bestückkopfes berücksichtigt und entsprechend kompensiert. Die Modularität eines selbständig kalibrierbaren Bestückkopfes hat den Nachteil, dass beim Austausch eines Bestückkopfes gegen einen Bestückkopf eines anderen Typs häufig einen Umbau oder zumindest eine erneute Kalibrierung eines die Bestückköpfe tragenden Positioniersystems erforderlich ist. Bei der Entwicklung von schnell wechselbaren Bestückköpfen ist es somit erforderlich, eine quasi standardisierte mechanische Schnittstelle zwischen Positioniersystem und Bestückkopf zu verwenden. Dies hat zu Folge, dass die einzelnen Bestückköpfe nicht optimal an die jeweiligen Anforderungen angepasst werden können, welche von Kunden gestellt werden, eine modular aufgebaute Bestückvorrichtungen zur Herstellung von unterschiedlichen elektronischen Baugruppen zu verwenden.

Aus der EP 1284096 B1 ist eine modular aufgebaute Bestückvorrichtung bekannt, bei der an einem als Chassis ausgebildeten passiven Stützkörper ein Träger angebracht ist. An dem Träger sind stationäre Teile eines Positioniersystems befestigt, welches zum zweidimensionalen Verfahren eines Bestückkopfes vorgesehen ist. Der Träger ist zusammen mit dem gesamten Positioniersystem und dem Bestückkopf als eine autonome Funktionseinheit ausgebildet und kann mit zugehörigen Steuereinheiten selbständig getestet und kalibriert werden. So kann die gesamte Funktionseinheit ggf. erst am Einsatzort der Bestückvorrichtung in das Chassis eingebaut werden. Die modular aufgebaute Bestückvorrichtung hat den Nachteil, dass die autonome und selbständig kalibrierbare Funktionseinheit keine kompakte austauschbare Komponente der Bestückvorrichtung darstellt. Vielmehr stellt diese Funktionseinheit selbst einen großen, schwer handhabbaren Teil der gesamten Bestückvorrichtung dar. Ein Austausch der autonomen Funktionseinheit ist deshalb sehr aufwendig und kann nur von geschultem Personal unter der Verwendung von speziellen Hilfsmitteln durchgeführt werden.

Der Erfindung liegt die Aufgabe zugrunde, eine modular aufgebaute Vorrichtung zum Bestücken von Substraten mit Objekten zu schaffen, welche einen einfachen und zügigen Umbau der Bestückvorrichtung bzw. einen einfachen und zügigen Austausch einer autonomen Funktionseinheit der Bestückvorrichtung ermöglicht.

Diese Aufgabe wird gelöst durch eine Vorrichtung zum Bestücken von Substraten mit Objekten, insbesondere zum Bestücken von Bauelementeträgern mit elektronischen Bauelementen, mit den Merkmalen des unabhängigen Anspruchs 1.

Der Erfindung liegt die Erkenntnis zugrunde, dass der gesamte Bestückroboter, welcher den Bestückkopf und wichtige Komponenten eines Flächen-Positioniersystems für den Bestückkopf umfasst, als selbständig kalibrierbares und schnell auswechselbares Modul ausgebildet ist. Somit können unterschiedliche Bestückköpfe, welche jeweils für eine bestimmte Bestückanwendung optimiert sind, zusammen mit einer an den jeweiligen Bestückkopf angepassten Positioniereinrichtung insbesondere bei einem Wechsel von zu bestückenden Baugruppen schnell ausgetauscht werden. Eine für einen präzisen Bestückvorgang erforderliche Kalibrierung der Funktionseinheit kann damit bereits im Vorfeld des Austausches außerhalb des Chassis durchgeführt werden, so dass eine erforderliche Umbauzeit der Bestückvorrichtung erheblich reduziert wird. Ferner können auf diese Weise für bestimmte Bestückanwendungen optimierte Funktionseinheiten verwendet werden, so dass auch die Effizienz einer Bestückvorrichtung erheblich gesteigert werden kann.

Ein leichtes Austauschen der autonomen Funktionseinheit wird durch eine standardisierte Schnittstelle erreicht, welche zwischen der stationären Linearführung der Positioniereinrichtung und dem beweglichen Positionierarm der Positioniereinrichtung verläuft.

Üblicherweise sind die beiden Linearführungen senkrecht zueinander orientiert, wobei die stationäre Linearführung beispielsweise entlang einer y-Richtung und die an dem Positionierarm angebrachte zweite Linearführung entlang einer zu der y-Richtung senkrecht orientierten x-Richtung verläuft.

Eine Kalibrierung der autonomen Funktionseinheit erfolgt bevorzugt mittels einer Hilfsvorrichtung, die zumindest in Teilen einem Bestückautomaten nachgebildet ist. Die Hilfsvorrichtung ermöglicht somit einen vollständigen Test der autonomen Funktionseinheit, so dass auch bei einem zugig durchführbaren Wechsel der autonomen Funktionseinheit eine hohe Prozesssicherheit gewährleistet werden kann.

Auf diese Weise ermöglicht die Erfindung den Aufbau von verschiedenen, hinsichtlich unterschiedlicher Kundenanforderungen optimierter Bestückroboter, welche auf einem das Chassis aufweisenden Maschinengrundmodul eingesetzt werden können. Somit kann dem Kunden eine auf seine jeweiligen Anforderungen hin optimierte Bestückvorrichtung angeboten werden, welche neben dem Maschinengrundmodul lediglich diejenigen Bestückroboter enthält, die für die jeweiligen Kundenanforderungen erforderlich sind.

Gemäß Anspruch 2 weist der Bestückkopf zusätzlich zumindest einen Hubantrieb auf, welcher zum Heben und Senken von aufgenommenen Objekten entlang einer zu den beiden Linearführungen winkligen Bewegungsrichtung eingerichtet ist. Abhängig von der Anzahl der an dem Bestückkopf vorgesehenen Bauelement-Haltevorrichtungen und der Anzahl der verwendeten Hubantriebe kann somit ein kollektives oder auch ein individuelles Bewegen einzelner Haltevorrichtungen bevorzugt entlang einer zu den beiden Linearführungen senkrechten z-Achse erfolgen.

Gemäß Anspruch 3 weist der Bestückkopf zusätzlich zumindest einen Drehantrieb auf, welcher zur Veränderung der Winkellage von aufgenommenen Objekten eingerichtet ist. Da bei dem Aufnehmen der Objekte aus einer Abholposition die aufzunehmenden Objekte üblicherweise in leicht unterschiedlichen Winkellagen bereitgestellt werden, ermöglicht eine gezielte Veränderung der Winkellage eines aufgenommenen Bauelements eine genaue Bestückung von Bauelementen.

Gemäß Anspruch 4 ist zusätzlich ein Elektronikmodul vorgesehen, welches der autonomen Funktionseinheit zugeordnet ist. Das Elektronikmodul kann einzelne oder auch eine Mehrzahl von Funktionalitäten aufweisen, welche beispielsweise in einer Ansteuerung des Führungsschlittens bzw. des Bestückkopfes oder in der Stromversorgung für Antriebsmotoren bestehen, welche dem Führungsschlitten und/oder dem Bestückkopf zugeordnet sind. Selbstverständlich können die einzelnen Funktionalitäten auch in individuellen Modulen enthalten sein.

Die für das Elektronikmodul erforderlichen Baugruppen, welche auch die für die Stromversorgung von Antriebsmotoren erforderliche Leistungselektronik umfassen, können heutzutage in einer miniaturisierten Bauweise hergestellt werden. Damit kann das Elektronikmodul der autonomen Funktionseinheit zugeordnet werden, ohne dass die Schnelligkeit des Bestückroboters infolge einer größeren trägen Masse des Elektronikmoduls verlangsamt wird.

Gemäß Anspruch 5 ist zusätzlich eine der autonomen Funktionseinheit zugeordnete Kamera vorgesehen, welche bevorzugt der Vermessung der Lage bzw. des Typs von durch den Bestückkopf aufgenommenen Bauelementen dient. Dies hat den Vorteil, dass nicht nur die Mechanik der autonomen Funktionseinheit außerhalb des Chassis kalibriert werden kann, sondern dass auch eine externe Kalibrierung eines Bilderkennungssystems außerhalb des eigentlichen Bestückautomaten möglich ist. Auf diese Weise kann zusätzlich die unproduktive Nebenzeit deutlich reduziert werden, welche durch den Stillstand der Bestückvorrichtung bei einem Wechsel des gesamten Bestückroboters entsteht.

Gemäß Anspruch 6 umfasst die autonome Funktionseinheit zusätzlich eine der Kamera nachgeschaltete Bildauswerteeinheit. Somit ist auf vorteilhafte Weise eine externe Kalibrierung des Bestückroboters auch hinsichtlich eines Bilderkennungs- bzw. Bildverarbeitungssystems möglich. Damit ist auch bei einem Austausch eines Bestückroboters, welcher zusätzlich zu seinen mechanischen Komponenten auch noch ein gesamtes Bildverarbeitungs- und Bildauswertesystem umfasst, eine hohe Prozesssicherheit möglich. Das Bildauswertesystem kann entweder in dem Elektronikmodul integriert sein oder in Form eines eigenen Bildauswertemoduls beispielsweise an dem Führungsschlitten oder an dem Positionierarm angebracht sein.

Gemäß Anspruch 7 ist außerdem eine für eine Bauteilerkennung erforderliche Beleuchtungseinheit der autonomen Funktionseinheit zugeordnet. Somit können sämtliche für ein Bilderkennungs- und Bildverarbeitungssystem erforderlichen elektronischen und optischen Komponenten außerhalb des Chassis kalibriert werden, so dass zum einen eine besonders starke Reduzierung von unproduktiven Nebenzeiten während des Austausches eines Bestückroboters und zum anderen eine hohe Prozesssicherheit nach dem Austausch eines Bestückroboters möglich ist.

Gemäß Anspruch 8 ist zwischen der stationären ersten Linearführung und dem Führungsschlitten eine lösbare Verbindung vorgesehen, welche eine räumlich genau definierte Ankopplung des Führungsschlittens an die stationäre erste Linearführung ermöglicht. Ein Austausch der als Bestück-Roboter ausgebildeten autonomen Funktionseinheit ist damit durch ein einfaches Abkoppeln des Führungsschlittens von der stationären ersten Linearführung möglich. Die Schnittstelle zwischen dem Grundmodul der Bestückvorrichtung und der autonomen Funktionseinheit verläuft somit zwischen der stationären ersten Linearführung und dem Führungsschlitten.

Gemäß Anspruch 9 ist eine lösbare Verbindung zwischen Führungsschlitten und Positionierarm vorgesehen. Die lösbare Verbindung, welche eine räumlich genau definierte Ankopplung des Positionierarms an dem Führungsschlitten ermöglicht, kann auf einfache Weise durch eine Verzahnung der beiden Komponenten Führungsschlitten und Positionierarm erreicht werden. Die Verzahnung kann durch Zentrierelemente, Nut- und Federelemente oder durch andere Arten von Fixierelementen realisiert werden.

Die Schnittstelle zwischen dem das Chassis aufweisenden Grundmodul der Bestückvorrichtung und der als Bestückroboter ausgebildeten autonomen Funktionseinheit verläuft somit zwischen dem Führungsschlitten und dem Positionierarm. Eine schnell lösbare und trotzdem räumlich genau definierte Verbindung des Führungsschlittens mit dem Positionierarm wird beispielsweise durch ein plattenförmiges Montageelement erreicht, welches mit dem Positionierarm fixiert ist und welches in einer genau definierten räumlichen Lage an den Führungsschlitten ankoppelbar ist.

Es wird darauf hingewiesen, dass bei dieser Weiterbildung der Erfindung der Führungsschlitten nicht der autonomen Funktionseinheit zugeordnet ist. In diesem Fall bietet es sich an, dass die für die Steuerung und den Antrieb des Führungsschlittens erforderliche Steuer- und Leistungselektronik ebenfalls nicht der autonomen Funktionseinheit zugeordnet wird, sondern dass die dafür erforderlichen elektronischen Komponenten an dem stationären Chassis der Bestückvorrichtung angebracht werden.

Weitere Vorteile und Merkmale der vorliegenden Erfindung ergeben sich aus der folgenden beispielhaften Beschreibung einer derzeit bevorzugten Ausführungsform.

In der Zeichnung zeigen in schematischen Darstellungen
Figur la eine modular aufgebaute Bestückvorrichtung gemäß einem Ausführungsbeispiel der Erfindung in einer Draufsicht und

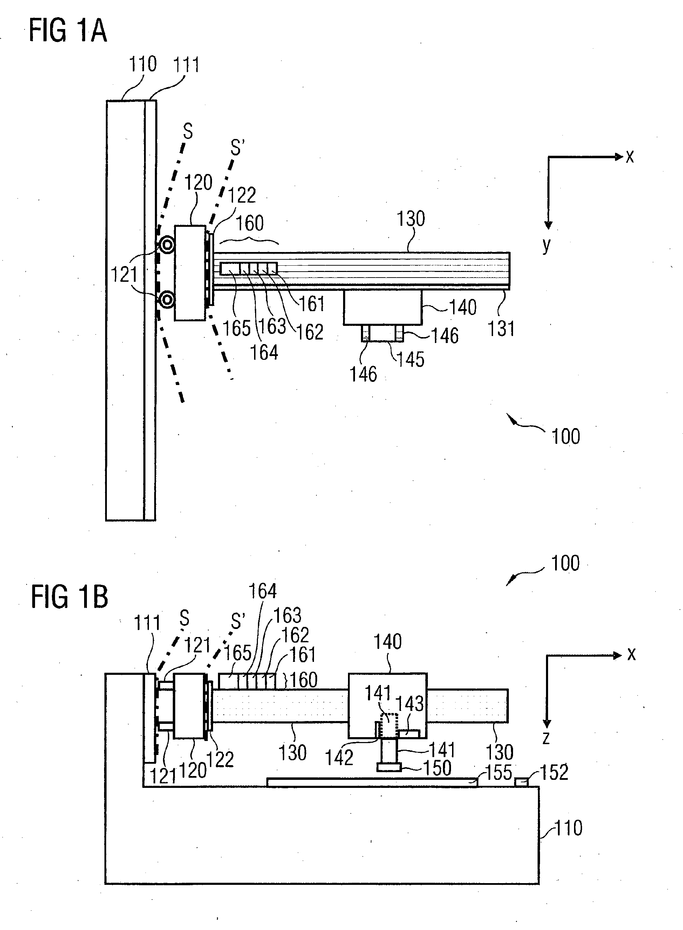

Figur 1b die in Figur 1 dargestellte modular aufgebaute Bestückvorrichtung in einer Querschnittsansicht.

Die in den Figuren 1a und 1b dargestellte Bestückvorrichtung 100 umfasst ein Chassis 110, an welchem eine stationäre Linearführung 111 angebracht ist. An der stationären Linearführung 111 ist über eine schematisch durch Rollen dargestellte Lagerung 121 ein Führungsschlitten verschiebbar befestigt, welcher entlang der Längserstreckung der stationären Linearführung 110, welche entlang einer y-Richtung verläuft, verschiebbar gelagert ist. Ein für eine gezielte Verfahrbewegung des Führungsschlittens 120 erforderlicher Antrieb ist aus Gründen der Übersichtlichkeit nicht dargestellt.

An dem Führungsschlitten 120 ist mittels einer Montageplatte 122 ein Positionierarm 130 befestigt, an welchem eine weitere Linearführung 131 ausgebildet ist. Der Bestückkopf 130 sowie die Linearführung 131 verlaufen entlang einer x-Richtung. An der Linearführung 131 ist ein Bestückkopf 140 verschiebbar gelagert, wobei ein für eine Verschiebung des Bestückkopfes 140 erforderlicher Antriebsmotor ebenfalls aus Gründen der Übersichtlichkeit nicht dargestellt ist.

Wie aus Figur 1b ersichtlich, umfasst der Bestückkopf 140 eine Haltevorrichtung 141, welche bevorzugt eine so genannte Saugpipette ist. Die Saugpipette überträgt einen von einer ebenfalls nicht dargestellten Vakuumerzeugungseinheit erzeugten Unterdruck auf ein Bauelement 150, so dass das Bauelement 150 durch eine Saugkraft von der Haltevorrichtung 141 gehalten wird. Um das Bauelement 150 auf vorgegebenen Einbaupositionen einer Leiterplatte 155 aufsetzen zu können, ist ein Hubantrieb 142 vorgesehen, welcher eine Bewegung der Haltevorrichtung 141 entlang einer z-Richtung ermöglicht. Um außerdem die Winkellage eines aufgenommenen Bauelements 150 zu verändern, ist die Haltevorrichtung 141 zusätzlich mit einem mechanischen Drehantrieb 143 gekoppelt, welcher eine Drehbewegung der Haltevorrichtung 141 ermöglicht.

Eine Überprüfung der Art eines durch die Haltevorrichtung 141 aufgenommenen Bauelements 150 sowie eine Lagevermessung des Bauelements 150 erfolgt mittels einer in Figur 1b dargestellten Bauelemente-Kamera 152. Die Bauelemente-Kamera 152 ist relativ zu dem Chassis 110 in einer festen räumlichen Lage angeordnet. Bevorzugt befindet sich die Bauelemente-Kamera 152 zwischen einer nicht dargestellten BauelementZuführeinrichtung, von welcher die Bauelemente 150 abgeholt werden, und einem Bestückbereich, in welchem die Leiterplatte 155 zum Zwecke der Bestückung positioniert wird.

Es wird darauf hingewiesen, dass die Bauelemente-Kamera auch an dem Bestückkopf 140 angebracht sein kann, wobei im Falle eines so genannten Matrix-Bestückkopfes, bei dem eine Mehrzahl von Haltevorrichtungen in einer parallelen Anordnung vorgesehen sind, beispielsweise durch entsprechende Spiegelanordnungen die aufgenommenen Bauelemente bevorzugt von der Unterseite erfassen kann. Bei Verwendung eines so genannten Revolverkopfes, bei dem eine Mehrzahl von Haltevorrichtungen sternförmig angeordnet um eine Drehachse drehbar gelagert sind, kann die Bauelemente-Kamera derart angeordnet sein, dass sich jeweils ein von der Haltevorrichtung aufgenommenes Bauelement erfasst werden kann, welches sich gerade in dem Erfassungsbereich der Bauelemente-Kamera befindet. Durch ein sequentielles getaktetes Drehen der sternförmig angeordneten Haltevorrichtungen können somit nacheinander sämtliche von dem Bestückkopf aufgenommenen Bauelemente vermessen werden.

Wie aus Figur 1a ersichtlich, ist an dem Bestückkopf 140 ein so genanntes Vision-System vorgesehen, welches eine Leiterplatten-Kamera 145 sowie zwei Beleuchtungseinheiten 146 umfasst. Mit Hilfe des Vision-Systems können auf der Leiterplatte 155 ausgebildete Positionsmarkierungen erkannt werden, so dass die Positionierung der Leiterplatte 155 in den Bestückbereich genau vermessen werden kann. Die Positionierung erfolgt mittels eines ebenfalls nicht dargestellten Leiterplatten-Transportsystems.

An dem Positionierarm 130 ist ferner ein Elektronikmodul 160 angebracht, welches eine erste Steuereinheit 161 zum Ansteuern des Führungsschlittens 120, eine zweite Steuereinheit 162 zum Ansteuern des Bestückkopfes 140, eine erste elektronische Leistungsbaugruppe 163 für einen nicht dargestellten und dem Führungsschlitten 120 zugeordneten ersten Antriebsmotor sowie eine zweite elektronische Leistungsbaugruppe 164 für einen ebenfalls nicht dargestellten und dem Bestückkopf 140 zugeordneten zweiten Antriebmotor aufweist. Zusätzlich umfasst das Elektronikmodul 160 noch eine Bildauswerteeinheit 165, welche sämtliche für die Kamera 145 sowie für die Beleuchtungseinheiten 146 erforderlichen elektronischen Baugruppen umfasst. Die Bildauswerteeinheit 165 sowie die beiden Steuereinheiten 161 und 162 sowie die beiden Stromversorgungseinheiten 163 und 164 können in Form von miniaturisierten elektronischen Schaltungen realisiert werden, so dass die träge Masse des Elektronikmoduls 160 so gering ist, dass die Beweglichkeit, das heißt die schnelle Verfahrbarkeit des Bestückkopfes 140 in lediglich zu vernachlässigender Weise eingeschränkt wird.

Gemäß der Erfindung werden bestimmte Teile der Bestückvorrichtung 100 einem so genannten Grundmodul zugeordnet, welches neben anderen, nicht dargestellten Komponenten wie beispielsweise einem Leiterplattentransport, unter anderem das Chassis 110 sowie die stationäre Linearführung 111 umfasst. Andere Komponenten der Bestückvorrichtung 100 werden einer autonomen Funktionseinheit zugeordnet, welche zumindest den Bestückkopf 140 und bewegliche Teile des den Bestückkopf 140 bewegenden Positioniersystems aufweist. Die autonome Funktionseinheit kann demzufolge als eigenständiger Bestückroboter gesehen werden, welcher den Positionierarm 130, die Linearführung 131 und den Bestückkopf 140 einschließlich Haltevorrichtungen 141, Hubantrieb 142, Drehantrieb 143 und Leiterplattenkamera 145 mit zugehörigen Beleuchtungseinheiten 146 umfasst. Da unterschiedliche Kunden mit der Bestückvorrichtung 100 üblicherweise auch unterschiedliche elektronische Baugruppen herstellen wollen, kann der Bestückroboter optimal dann die vom Kunden gestellte Anforderungen angepasst werden.

Der modulare Aufbau der Bestückvorrichtung schafft somit die Möglichkeit, dass bei außergewöhnlichen Bestückapplikationen mit beispielsweise besonders hohen Bauelementen oder mit extrem kleinen Bauelementen die geometrische Anordnung der Positioniereinrichtung in Bezug auf das jeweilige Bestückprogramm optimal gewählt werden kann. So kann beispielsweise die jeweils für eine zügige Bestückung optimale Transporthöhe gewählt werden, in welcher der Bestückkopf parallel zu dem zu bestückenden Substrat verfahren wird.

Wie aus den Figuren 1a und 1b ersichtlich, können unterschiedliche Schnittstellen S bzw. S' gewählt werden, über die das Grundmodul der Bestückvorrichtung 100 sowie der als autonome Funktionseinheit ausgebildete Bestückroboter schnell lösbar miteinander gekoppelt werden können.

So kann eine Schnittstelle S zwischen der stationären Linearführung 111 und dem Führungsschlitten 120 gewählt werden, so dass sämtliche beweglichen Teile der Positioniereinrichtung dem als autonome Funktionseinheit ausgebildeten Bestückroboter zugeordnet sind. Dies hat den Vorteil, dass der gesamte Bestückroboter mit einfachen Handhabungswerkzeugen ausgetauscht werden kann, da nicht nur die beweglichen mechanischen Komponenten der Positioniereinrichtung, sondern auch die für die Positioniereinrichtung erforderlichen Antriebsmotoren sowie die für die Antriebsmotoren erforderliche Antriebselektronik dem Bestückroboter zugeordnet sind.

Die Schnittstelle zwischen dem Grundmodul der Bestückvorrichtung 100 und dem als autonome Funktionseinheit ausgebildeten Bestückroboter kann auch zwischen dem Führungsschlitten 120 und der Montageplatte 122 liegen (Schnittstelle S'), so dass auch eine bewegliche Komponente des Positioniersystems, nämlich der Führungsschlitten 120, dem Grundmodul der Bestückvorrichtung 100 zugeordnet ist. Die Verwendung der Schnittstelle S' hat den Vorteil, dass die Montageplatte 122 auf einfache Weise lösbar an dem Führungsschlitten 120 angekoppelt werden kann. Für eine genaue räumliche Fixierung der Montageplatte 122 an dem Führungsschlitten 120 sind in der Zeichnung nicht dargestellte Fixier- bzw. Zentrierelemente vorgesehen. Ein Austausch des Bestückroboters, welcher in diesem Fall lediglich den Bestückkopf 140 sowie eine lineare, entlang der x-Achse verlaufende Positioniereinrichtung umfasst, kann somit auf besonders einfache Art und Weise durchgeführt werden. Ein Auseinandernehmen der Lagerung 121 ist demzufolge nicht erforderlich.

Zusammenfassend bleibt festzustellen: Die Erfindung schafft eine modular aufgebaute Vorrichtung zum Bestücken von Substraten 155 mit Objekten 150, insbesondere zum Bestücken von Bauelementeträgern mit elektronischen Bauelementen. Die Bestückvorrichtung 100 umfasst ein Chassis 110, eine an dem Chassis 110 angebrachte stationäre erste Linearführung 111, einen an der stationären Linearführung 111 verschiebbar gelagerten Führungsschlitten 120, einen an dem Führungsschlitten 120 befestigten Positionierarm 130, an welchem eine zweite Linearführung 131 angebracht ist, und einen an der zweiten Linearführung 131 verschiebbar gelagerten Bestückkopf 140. Gemäß der Erfindung ist der Positionierarm 130 zusammen mit dem Bestückkopf 140 als autonome Funktionseinheit ausgebildet, welche außerhalb des Chassis 110 kalibrierbar ist. Die autonome Funktionseinheit stellt einen eigenständigen Bestückroboter dar, welcher mit einem Grundmodul der Bestückvorrichtung 100 über eine definierte Schnittstelle S, S' lösbar gekoppelt werden kann. Das Grundmodul weist neben anderen Komponenten der Bestückvorrichtung 100 zumindest das Chassis 110 und die stationäre Linearführung 111 auf. Durch die Möglichkeit der externen Kalibrierung kann der Bestückroboter schnell ausgetauscht werden, wobei der Bestückbetrieb nur für kurze Zeit unterbrochen werden muss. Somit können verschiedene Bestückroboter für unterschiedliche Bestückanwendungen bereitgestellt werden.

### Bezugszeichenliste

- 100: Bestückvorrichtung
- 110: Chassis
- 111: stationäre Linearführung
- 120: Führungsschlitten
- 121: Lagerung
- 122: Montageplatte
- 130: Positionierarm
- 131: Linearführung
- 140: Bestückkopf
- 141: Haltevorrichtung
- 142: Hubantrieb
- 143: Drehantrieb
- 145: Leiterplatten-Kamera
- 146: Beleuchtungseinheit
- 150: Bauelement
- 152: Bauelement-Kamera
- 155: Leiterplatte
- 160: Elektronikmodul
- 161: erste Steuereinheit
- 162: zweite Steuereinheit
- 163: erste elektronische Leistungsbaugruppe
- 164: zweite elektronische Leistungsbaugruppe
- 165: Bildauswerteeinheit, ggf. mit für Kamera und Beleuchtung erforderlichen elektronischen Baugruppen

- S: Schnittstelle
- S': alternative Schnittstelle

## Patentansprüche

1. Vorrichtung zum Bestücken von Substraten (155) mit Objekten (150), insbesondere zum Bestücken von Bauelementeträgern mit elektronischen Bauelementen, mit
einem Chassis (110),
einer an dem Chassis (110) angebrachten stationären ersten Linearführung (111),
einem an der stationären Linearführung (111) verschiebbar gelagerten Führungsschlitten (120),
einem an dem Führungsschlitten (120) befestigten Positionierarm (130), an welchem eine zweite Linearführung (131) angebracht ist, und
einem an der zweiten Linearführung (131) verschiebbar gelagerten Bestückkopf (140), eingerichtet zum temporären Aufnehmen, Transportieren und Abgeben von Objekten (150) an vorgegebenen Einbaupositionen eines Substrates (155),
**dadurch gekennzeichnet, dass**
der Positionierarm (130) zusammen mit dem Bestückkopf (140) als austauschbare und außerhalb des Chassis (110) kalibriebare Funktionseinheit ausgebildet ist, so dass eine für einen präzisen Bestückvorgang erforderliche Kalibrierung der Funktionseinheit außerhalb des Chassis (110) durchgeführt werden kann, wobei die Funktionseinheit über Schnittstellen (S, S') lösbar mit der stationären ersten Linearführung (111) und dem Chassis (110) verbunden ist.

2. Vorrichtung nach Anspruch 1, bei der
der Bestückkopf (140) zusätzlich einen Hubantrieb (142) aufweist, welcher zum Heben und Senken von aufgenommenen Objekten (150) entlang einer zu den beiden Linearführungen (111, 131) winkligen Bewegungsrichtung eingerichtet ist.

3. Vorrichtung nach einem der Ansprüche 1 bis 2, bei der
der Bestückkopf (140) zusätzlich einen Drehantrieb (143) aufweist, welcher zur Veränderung der Winkellage von aufgenommenen Objekten (150) eingerichtet ist.

4. Vorrichtung nach einem der Ansprüche 1 bis 3, bei der zusätzlich ein der autonomen Funktionseinheit zugeordnetes Elektronikmodul (160) vorgesehen ist, welches eine erste Steuereinheit (161) zum Ansteuern des Führungsschlittens (120),
eine zweite Steuereinheit (162) zum Ansteuern des Bestückkopfes (140),
eine erste Stromversorgungseinheit (163) für einen dem Führungsschlitten (120) zugeordneten ersten Antriebsmotor und/oder
eine zweite Stromversorgungseinheit (164) für einen dem Bestückkopf (140) zugeordneten zweiten Antriebsmotor aufweist.

5. Vorrichtung nach einem der Ansprüche 1 bis 3, bei der
zusätzlich eine der autonomen Funktionseinheit zugeordnete Kamera (145) vorgesehen ist.

6. Vorrichtung nach Anspruch 5, bei der
zusätzlich eine der autonomen Funktionseinheit zugeordnete und der Kamera (145) nachgeschaltete Bildauswerteeinheit (165) vorgesehen ist.

7. Vorrichtung nach einem der Ansprüche 1 bis 6, bei der
zusätzlich eine der autonomen Funktionseinheit zugeordnete Beleuchtungseinheit (146) vorgesehen ist.

8. Vorrichtung nach einem der Ansprüche 1 bis 7, bei der
zwischen der stationären ersten Linearführung (111) und dem Führungsschlitten (120) eine lösbare Verbindung (S) vorgesehen ist, welche eine räumlich genau definierte Ankopplung des Führungsschlittens (120) an die stationäre erste Linearführung (111) ermöglicht.

9. Vorrichtung nach einem der Ansprüche 1 bis 7, bei der
zwischen Führungsschlitten (120) und Positionierarm (130) eine lösbare Verbindung (S') vorgesehen ist, welche eine räumlich genau definierte Ankopplung des Positionierarms (130) an den Führungsschlitten (120) ermöglicht.

10. Vorrichtung nach einem der Ansprüche 1 bis 9, bei welcher eine standardisierte Schnittstelle zum Entnehmen der autonomen Funktionseinheit vorgesehen ist, die zwischen der stationären Linearführung (111) und dem Positionierarm (130) der autonomen Funktionseinheit verläuft.

11. Bestücksystem umfassend eine Vorrichtung zum Bestücken gemäß einem der vorstehenden Ansprüche und eine weitere Funktionseinheit, wobei die weitere Funktionseinheit einen weiteren Positionierarm mit einer weiteren zweite Linearführung
und
einen an der weiteren zweiten Linearführung verschiebbar gelagerten weiteren Bestückkopf, eingerichtet zum temporären Aufnehmen, Transportieren und Abgeben von Objekten an vorgegebenen Einbaupositionen eines Substrates, umfasst,
und
wobei weiterhin die Funktionseinheit und die weitere Funktionseinheit
gegeneinander austauschbar sind.

## Claims

1. A device for mounting substrates (155) with objects (150), in particular for mounting component carriers with electronic components, comprising
a chassis (110),
a stationary first linear guide (111), which is attached to said chassis (110),
a guiding carriage (120), which is displaceably mounted on the stationary first linear guide (111),
a positioning arm (130), which is fastened to the guiding carriage (120) and to which a second linear guide (131) is attached, and
a mounting head (140), which is displaceably mounted on the second linear guide (131) and which is adapted for temporarily receiving, transporting and delivering objects (150) at predefined assembly positions of a substrate (155),
**characterized in that**
the positioning arm (130) is formed together with the mounting head (140) as an autonomous functional unit, which can be replaced and calibrated outside of the chassis (110), so that a calibration of the functional unit required for a precise mounting process can be carried out outside of the chassis (110), wherein the functional unit is releasably connected via interfaces (S, S') to the stationary first linear guide (111) and the chassis 110).

2. The device according to claim 1, wherein
the mounting head (140) in addition has a lifting drive (142), which is adapted for lifting and lowering received objects (150) along a movement direction which is angular to the two linear guides (111, 131).

3. The device according to any one of the claims 1 to 2,
wherein
the mounting head (140) in addition has a rotary drive (143), which is adapted for changing the angular position of received objects (150).

4. The device according to any one of the claims 1 to 3,
wherein,
in addition, an electronic module (160) is provided, which is associated with the autonomous functional unit, and which comprises
a first control unit (161) for controlling the guide carriage (120),
a second control unit (162) for controlling the mounting head (140),
a first power supply unit (163) for a first drive motor associated with the guide carriage (120),
and/or
a second power supply unit (164) for a second drive motor associated with the mounting head (140).

5. The device according to any one of the claims 1 to 3,
wherein,
in addition, a camera (145) is provided, which is associated with the autonomous functional unit.

6. The device according to claim 5, wherein,
in addition, an image evaluation unit (165) is provided, which is associated with the autonomous functional unit and is located downstream of the camera (145).

7. The device according to any one of the claims 1 to 6,
wherein,
in addition, a lighting unit (146) is provided, which is associated with the autonomous functional unit.

8. The device according to any one of the claims 1 to 7,
wherein
between the stationary first linear guide (111) and the guide carriage (120), a releasable connection (S) is provided, which enables a spatially accurately defined coupling of the guide carriage (120) to the stationary first linear guide (111).

9. The device according to any one of the claims 1 to 7,
wherein
between the guide carriage (120) and the positioning arm (130), a releasable connection (S') is provided, which allows a spatially accurately defined coupling of the positioning arm (130) to the guide carriage (120).

10. The device according to any one of the claims 1 to 9,
wherein
a standardized interface for removing the autonomous functional unit is provided, which interface runs between the stationary linear guide (111) and the positioning arm (130) of the autonomous functional unit.

11. A mounting system, comprising a device for mounting according to any one of the preceding claims, and a further functional unit, wherein the further functional unit comprises a further positioning arm with a further second linear guide
and
a further mounting head, which is displaceably mounted on the further second linear guide and which is adapted for temporarily receiving, transporting and delivering objects at predefined assembly positions of a substrate,
and
wherein, furthermore, the functional unit and the further functional unit are interchangeable.

## Revendications

1. Dispositif pour équiper des substrats (155) avec des objets (150), en particulier pour équiper des supports de composants avec des composants électroniques, avec
un châssis (110),
un premier dispositif de guidage linéaire (111) stationnaire monté sur le châssis (110),
un chariot de guidage (120) monté de manière mobile sur le dispositif de guidage linéaire (111) stationnaire,
un bras de positionnement (130) fixé sur le chariot de guidage (120), sur lequel est monté un deuxième dispositif de guidage linéaire (131), et
une tête d'équipement (140) montée de manière mobile sur le deuxième dispositif de guidage linéaire (131), étudiée pour la réception temporaire, le transport et la délivrance d'objets (150) au niveau de positions de montage prescrites d'un substrat (155),
**caractérisé en ce que**
le bras de positionnement (130) est réalisé ensemble avec la tête d'équipement (140) en tant qu'unité fonctionnelle échangeable et pouvant être calibrée en-dehors du châssis (110), de sorte qu'il est possible de réaliser un calibrage nécessaire pour un processus d'équipement précis de l'unité fonctionnelle en-dehors du châssis (110), l'unité fonctionnelle étant reliée de manière détachable via des interfaces (S, S') au premier dispositif de guidage linéaire (111) stationnaire et au châssis (110).

2. Dispositif selon la revendication 1, dans lequel la tête d'équipement (140) présente de manière supplémentaire un entraînement de levage (142), lequel est étudié pour lever et abaisser des objets (150) saisis le long d'une direction de déplacement angulaire par rapport aux deux dispositifs de guidage linéaire (111, 131).

3. Dispositif selon l'une des revendications 1 à 2, dans lequel
la tête d'équipement (140) présente de manière supplémentaire un entraînement rotatif (143), lequel est étudié pour la modification de la position angulaire d'objets (150) saisis.

4. Dispositif selon l'une des revendications 1 à 3, dans lequel on prévoit de manière supplémentaire un module électronique (160) associé à l'unité fonctionnelle autonome, lequel présente
une première unité de commande (161) pour la commande du chariot de guidage (120),
une deuxième unité de commande (162) pour la commande de la tête d'équipement (140),
une première unité d'alimentation électrique (163) pour un premier moteur d'entraînement associé au chariot d'entraînement (120) et/ou
une deuxième unité d'alimentation électrique (164) pour un deuxième moteur d'entraînement associé à la tête d'équipement (140).

5. Dispositif selon l'une des revendications 1 à 3, dans lequel
on prévoit de manière supplémentaire une caméra (145) associée à l'unité fonctionnelle autonome.

6. Dispositif selon la revendication 5, dans lequel on prévoit de manière supplémentaire une unité d'analyse d'image (165) associée à l'unité fonctionnelle autonome et montée en aval de la caméra (145).

7. Dispositif selon l'une des revendications 1 à 6, dans lequel
l'on prévoit de manière supplémentaire une unité d'éclairage (146) associée à l'unité fonctionnelle autonome.

8. Dispositif selon l'une des revendications 1 à 7, dans lequel
on prévoit une liaison détachable (S) entre le premier dispositif de guidage linéaire (111) stationnaire et le chariot de guidage (120), laquelle permet un accouplement défini avec précision dans l'espace du chariot de guidage (120) avec le premier dispositif de guidage linéaire (111) stationnaire.

9. Dispositif selon l'une des revendications 1 à 7, dans lequel
on prévoit une liaison détachable (S') entre le chariot de guidage (120) et le bras de positionnement (130), laquelle permet un accouplement défini avec précision dans l'espace du bras de positionnement (130) avec le chariot de guidage (120).

10. Dispositif selon l'une des revendications 1 à 9, dans lequel
on prévoit une interface standardisée pour le prélèvement de l'unité fonctionnelle autonome, laquelle s'étend entre le dispositif de guidage linéaire (111) stationnaire et le bras de positionnement (130) de l'unité fonctionnelle autonome.

11. Système d'équipement comprenant un dispositif pour l'équipement selon l'une des revendications précédentes et une autre unité fonctionnelle, l'autre unité fonctionnelle comprenant un autre bras de positionnement avec un autre deuxième dispositif de guidage linéaire
et
une autre tête d'équipement montée de manière mobile sur l'autre deuxième dispositif de guidage linéaire, étudiée pour la réception temporaire, le transport et la délivrance d'objets au niveau de positions de montage prescrites d'un substrat,
et
l'unité fonctionnelle et l'autre unité fonctionnelle étant en outre interchangeables l'une avec l'autre.
